# EUROPEAN PATENT APPLICATION

(11) **EP 2 059 106 A2**
(43) Date of publication of application: **13.05.2009**
(21) Application number: 08018492.2
(22) Date of filing: 22.10.2008
(51) Int. Cl.: H05K 7/20

(54) **Information display board**

(30) Priority: 08.11.2007 GB 0721932
(71) Applicant: Harp Visual Communications Limited, Lower Swanwick Southhampton SO31 7GB (GB)
(72) Inventor: Gould, Adrian Jeremy, Hampshire PO15 7HJ (GB)
(74) Representative: Brooks, Nigel Samuel

(57) **Abstract**

Referring to the drawings, an information display board 1 has a LCD display 2 within an enclosure 3. Around a joint line 8 incorporating hinges 6 and a lock 7, a seal 9 is provided. The enclosure is hermetic, which inhibits convective cooling of the display.

The LCD display 2 has a surrounding metal frame 10, with an upper run 11 below a top wall 12 of the enclosure. This wall is long and narrow, the enclosure being shallow from its window 5 to its back wall 14. Mounted on the top wall, outside the enclosure, is a pair of heat dissipating heat sinks 15. It has peripheral groove 16 in its underside, occupied by an O-ring seal 17. This seals against the top wall 12. Within the seal, the wall has a number of openings 18. A corresponding number of Peltier devices 19 are mounted in the openings contacting the upper run of the frame with their cold sides and the underside of heat sink with their hot sides. In use, with the LCD becoming heated by use and voltage applied to the Peltier devices, heat is drawn from the LCD via its frame and transferred to the heat sink.

To assist in dissipation of the heat from the heat sink, fans 21 are provided above the heat sink. These are driven by motors 22. The latter are mounted within the enclosure in horns 23 at either side. The top wall 12 is turned up at the insides - facing each other - of the horns. Output shafts 24 of the motors pass through the turned up portions 25 of the horns at seals 26, whereby although the fans operate outside the enclosure, their motors remain inside.

## Description

The present invention relates to an information display board. In certain environments, such as underground railway stations, stringent efforts are made to reduce risk of fire. At the same time many more electrical devices are being installed, particularly information display units. To reduce the risk of fire from such devices, they are enclosed. However, enclosure gives rise to its own problems in restricting heat dissipation.

The object of the present invention is to provide an improved information display unit.

According to the invention there is provided an information display board comprising;
- a visual display unit liable to generate heat during information display,
- an enclosure for the visual display unit, the enclosure having:

- plurality of walls, one being transparent, enclosing the visual display unit,
- one or more heat transfer devices for transferring heat from the visual display unit,
- a heat dissipation element arranged on the outside of the enclosure for receiving heat from the heat transfer devices through a wall of the device for its dissipation outside the enclosure.

Normally the visual display unit will be a flat screen unit and in particular a liquid crystal display unit.

Preferably the heat transfer devices are Peltier devices. Conveniently, these are arranged to draw heat from a frame of the visual display unit and transfer it via openings in one wall of the enclosure to the heat dissipation element.

The heat dissipation device will normally be a finned heat sink, namely a block of grooved aluminium.

Where as normally will be the case, the enclosure is hermetic to the extent of preventing ingress of oxygen in the event of overheating to flash point of the display, the finned heat sink forms part of the sealed enclosure, conveniently being provided with a groove in its face for sealing abutment with one wall of the enclosure.

Where the rate of heat dissipation is such that forced convection is required, a fan can be provided externally of enclosure, driven by a motor housed internally of the enclosure. A shaft between the fan and the motor is provided with a seal where it passes through a wall of the enclosure.

To help understanding of the invention, a specific embodiment thereof will now be described by way of example and with reference to the accompanying drawings, in which:

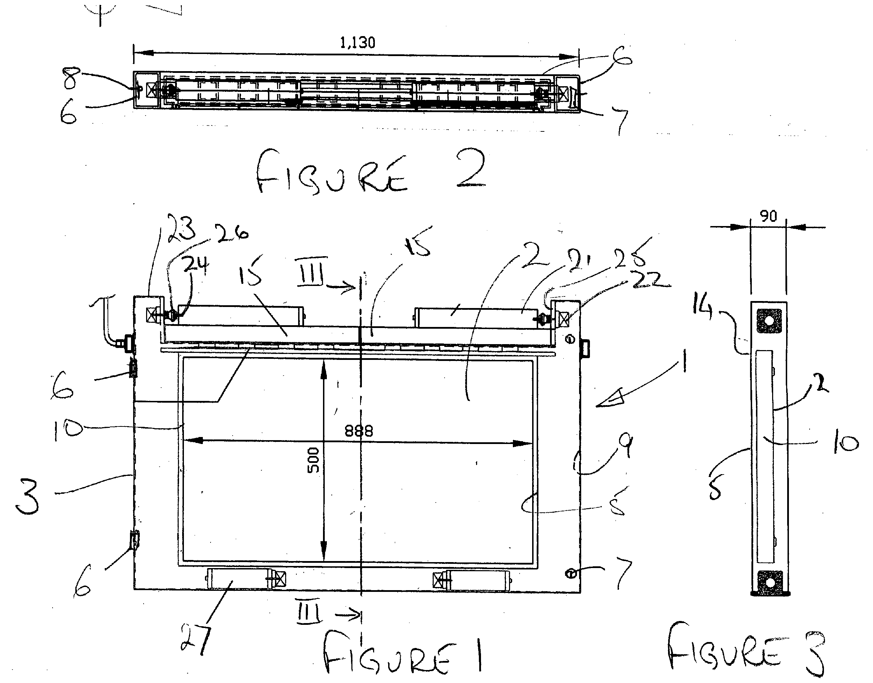

Figure 1 is a front view of an inform ation display board in accordance with the invention;
Figure 2 is a plan view of the displ ay board of Figure 1;
Figure 3 is a cross-sectional end vi ew on the line III-III in Figure 1; and

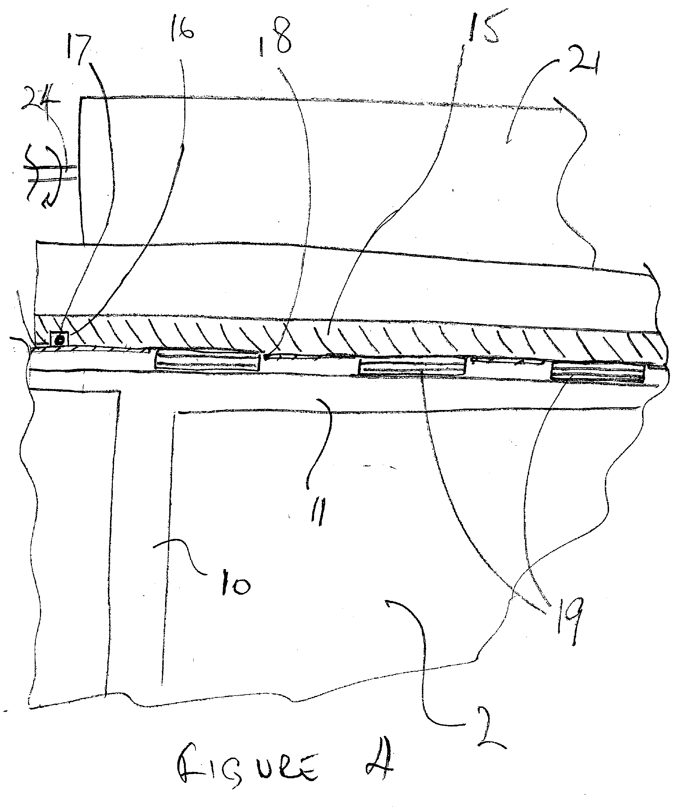

Figure 4 is a scrap cross-sectional front view on a larger scale.

Referring to the drawings, an information display board 1 has a LCD display 2 within an enclosure 3. Essentially this is an openable aluminium case having aluminium walls 4 and a window 5, through which the display can be viewed. The enclosure has hinges 6 and a lock 7. Around a joint line 8 incorporating the hinges and the lock, a seal 9 is provided. The enclosure is sufficiently hermetic that in the event of overheating of the wall, should the flash point of its components be reached, the flames will be short lived due to the inability of oxygen from the ambient atmosphere to enter the enclosure. This sealing inhibits convective cooling of the display.

The LCD display 2 has a surrounding metal frame 10, via which it is supported in the enclosure with an upper run 11 of the frame close below a top wall 12 of the enclosure. This wall is long and narrow, the enclosure being shallow from its window 5 to its back wall 14. Mounted on the top wall, outside the enclosure, is a pair of heat dissipating heat sinks 15 in the form of a finned block of aluminium, attached to the wall by non-shown fixtures. It has peripheral groove 16 in its underside, occupied by an O-ring seal 17. This seals against the top wall 12. Within the seal, the wall has a number of openings 18. A corresponding number of Peltier devices 19 are mounted in the openings contacting the upper run of the frame with their cold sides (or at least the sides made cold when voltage is applied to them) and the underside of heat sink with their hot sides. In use, with the LCD becoming heated by use and voltage applied to the Peltier devices, heat is drawn from the LCD via its frame and transferred to the heat sink.

To assist in dissipation of the heat from the heat sink, fans 21 are provided above the heat sink. These are driven by motors 22. The latter are mounted within the enclosure in horns 23 at either side. The top wall 12 is turned up at the insides - facing each other - of the horns. Output shafts 24 of the motors pass through the turned up portions 25 of the horns at seals 26, whereby although the fans operate outside the enclosure, their motors remain inside, where they are protected from environmental contamination.

A final point of detail is that stirrer fans and motors 27 are provided at the bottom enclosure for circulating the atmosphere within the enclosure to even out the temperature of the components within it.

Apart from the advantage to containing any fire risk, the arrangement of the fan motors 22 within the enclosure isolates them from dust in the ambient atmosphere.

## Claims

1. An information display board comprising;
• a visual display unit liable to generate heat during information display,
• an enclosure for the visual display unit, the enclosure having:
• plurality of walls, one being transparent, enclosing the visual display unit,
• one or more heat transfer devices for transferring heat from the visual display unit and
• a heat dissipation element arranged on the outside of the enclosure for receiving heat from the heat transfer devices through a wall of the device for its dissipation outside the enclosure.

2. An information display board as claimed in claim 1, wherein the visual display unit is a flat screen unit.

3. An information display board as claimed in claim 1 or claim 2, wherein the visual display unit is a liquid crystal display unit.

4. An information display board as claimed in claim 1 or claim 2 or claim 3, wherein the or each heat transfer device is a Peltier device.

5. An information display board as claimed in claim 5, wherein the or each Peltier device is arranged to draw heat from a frame of the visual display unit and transfer it via openings in one wall of the enclosure to the heat dissipation element.

6. An information display board as claimed in any preceding claim, wherein be a finned heat sink

7. An information display board as claimed in claim 7, wherein the heat dissipation device is a block of grooved aluminium.

8. An information display board as claimed in claim 7 or claim 8, wherein the enclosure is hermetic to the extent of preventing ingress of oxygen in the event of overheating to flash point of the display and the finned heat sink forms part of the sealed enclosure

9. An information display board as claimed in claim 9, wherein the finned heat sink is provided with a groove in its face for sealing abutment with one wall of the enclosure.

10. An information display board as claimed in any preceding claim, including:
• a fan provided externally of the enclosure, and
• for driving the fan, a motor housed internally of the enclosure. A shaft between the fan and the motor is provided with a seal where it passes through a wall of the enclosure.

11. An information display board as claimed in any preceding claim, including stirrer fans and motors provided at the bottom enclosure for circulating the atmosphere within the enclosure to even out the temperature of the components within it.
